# EUROPÄISCHE PATENTANMELDUNG

(11) **EP 0 551 118 A1**
(43) Veröffentlichungstag der Anmeldung: **14.07.1993**
(21) Anmeldenummer: 93100195.2
(22) Anmeldetag: 08.01.1993
(51) Int. Cl.: G02B 6/12, G02F 1/01

(54) **Verfahren zur Herstellung von nicht linearen optischen Mikro-Bauelementen**

(30) Priorität: 10.01.1992 DE 4200397
(71) Anmelder: INSTITUT FÜR MIKROTECHNIK MAINZ GmbH, D-55129 Mainz-Hechtsheim (DE)
(72) Erfinder: Ehrfeld, Wolfgang Prof. Dr., W - 6500 Mainz (DE); Moser, Herbert O.,Dr., W - 75000 Karlsruhe 41 (DE); Müllen,Klaus,Prof.Dr., W - 6500 Mainz (DE); Bubeck, Christoph,Dr., W - 6228 Eltville 5 (DE); Bauer, Hans-Dieter, Dr., W - 6501 Partenheim (DE)
(74) Vertreter: Fuchs, Luderschmidt & Partner Patentanwälte

(57) **Zusammenfassung**

Es wird ein Verfahren zur Herstellung von nicht linearen optischen Mikrobauelementen beschrieben, mit dem der Einsatz bisher noch nicht verwendeter Materialkombinationen ermöglicht wird. Mittels der Röntgentiefenlithographie werden nicht nur Wellenleiterstrukturen sondern auch Mikroküvettenstrukturen hergestellt, in die anschließend Material mit nicht linearen optischen Eigenschaften eingebracht wird. Mittels der Röntgentiefenlithographie und Mikroabformtechnik wird ein Formeinsatz mit einer Wellenleiterstruktur als Positivform hergestellt und die Wellenleiterstruktur mittels des Formeinsatzes in ein Trägermaterial aus Polymeren eingeprägt. Danach wird die eingeprägte Wellenleiterstruktur mit optisch linearem Material gefüllt und nach dem Ausfüllen mittels der Röntgentiefenlithographie zumindest in den Bereichen des optisch linearen Materials mindestens eine Mikroküvettenstruktur hergestellt, in die optisch nicht lineares Material eingebracht wird. Die Mikroküvettenstruktur kann auch mittels eines weiteren Formeinsatzes eingeprägt werden.

## Beschreibung

Die Erfindung betrifft ein Verfahren zur Herstellung von nicht linearen optischen Mikrobauelementen, bei dem mittels Röntgentiefenlithographie und Mikroabformtechnik ein Formeinsatz mit einer Wellenleiterstruktur als Positivform hergestellt wird, die Wellenleiterstruktur mittels des Formeinsatzes in ein Trägermaterial aus Polymeren eingeprägt wird und anschließend die eingeprägte Wellenleiterstruktur mit optisch linearem Material gefüllt wird.

Optische Mikrobauelemente finden Verwendung in optischen Miniaturschaltungen, in denen Lichtsignale erzeugt, durch Wellenleitungen in einer Ebene geführt und verarbeitet sowie nachgewiesen werden können. Die bisher wichtigsten Substratmaterialien für die Herstellung integrierter optischer Bauteile sind Glas, Lithiumniobat und Silizium. Die Klasse der 3-5 Halbleitermaterialien hat insbesondere für die monolithische Integration von passiven Wellenleiterstrukturen und optoelektronischen Bauelementen große Bedeutung gewonnen.

Aus "Technisches Messen, Sonderheft zur Sensor 91", 58 (1991) 4, S. 152 - 157 ist ein Verfahren zur Herstellung optischer Mikrobauelemente bekannt, bei dem von einem Glasstab Wafer abgeschnitten werden. Der nachfolgende Fotolithographieprozess beginnt mit der Herstellung einer geeignet strukturierten Urmaske auf einem Elektronenstrahlschreiber, die im Direktkontaktverfahren auf den zuvor mit Metall und Fotolack beschichteten Glaswafer kopiert wird. Nach der Entwicklung des Lackes und dem Durchätzen der Metallschicht in den offenen Lackbereichen liegt die angestrebte Wellenleiterstruktur als Metallmaske vor. Zur Erzeugung der Wellenleiter werden die Glaswafer in eine heiße Salzschmelze eingebracht, wo Metallionen aus der Schmelze von Konzentrationsgradienten angetrieben durch die Maskenöffnungen in die Glasoberfläche eindringen und dort die Brechzahl erhöhen. Nach Ablösung der Maske werden einzelne Chips aus dem Glaswafer ausgesägt und deren Stirnflächen für die spätere Faserankopplung poliert. Derart hergestellte Wellenleiter haben ihr Brechzahlmaximum direkt an der Glasoberfläche.

Eine Abschirmung der geführten Lichtwellen gelingt durch das Vergraben der Fremdionen unter die Substratoberfläche in einem zweiten Austauschschritt, der sowohl diffusionskontrolliert (thermisch) als auch driftkontrolliert (feldunterstützt) geführt werden kann.

Zur Herstellung eines nicht linearen optischen Mikrobauelementes auf der Basis von Lithiumniobat wird - wie in "Spektrum der Wissenschaft" Dezember 1986, Seite 116 ff beschrieben - zunächst ein Einkristall aus Lithiumniobat hergestellt, auf dessen Oberfläche ein dünner Titanfilm fotolithographisch mit Hilfe einer Maske aufgebracht wird, um dem Einkristall die gewünschte Wellenleiterstruktur zu geben. Danach wird die gesamte Anordnung auf etwa 1000°C aufgeheizt, so daß das Titan in die äußerste Oberfläche des Lithiumniobats eingebracht wird. Das verbleibende Titan wird weggeätzt.

Der Nachteil dieser Verfahren besteht darin, daß die Auswahl der Materialien für die Herstellung nichtlinearer optischer Bauelemente beschränkt ist. Insbesondere die Kombination von optisch-linearen und optisch nichtlinearen Materialien läßt sich nicht in der gewünschten Vielfalt realisieren. Darüber hinaus sind diese bekannten Verfahren für eine Massenfertigung von nichtlinearen optischen Mikrobauelementen zu aufwendig.

Um den Werkstoff der Polymeren für den Einsatz von Wellenleitern in Mikrobauelementen zu erschließen, wurde in der Vergangenheit bereits die Röntgentiefenlithographie eingesetzt (siehe z.B. DE-PS 36 11 246). Aus einem Röntgen-Resist-Material, können mittels der Röntgentiefenlithographie Wellenleiterstrukturen herausgearbeitet werden, die zur Ausbildung von Wellenleitern mit einem geeigneten Polymermaterial ausgefüllt werden. Mittels der Röntgentiefenlithographie und der Galvanoformung können auch Formeinsätze hergestellt werden, mittels derer Wellenleiterstrukturen in Polymermaterialien einprägbar sind. Diese Verfahren wurden bisher nur für die Herstellung optisch-linearer Mikrobauelemente eingesetzt.

Aufgabe der Erfindung ist es, ein Verfahren bereitzustellen, mit dem nichtlineare optische Mikrobauelemente hergestellt werden können, wobei der Einsatz bisher noch nicht verwendeter Materialkombinationen, insbesondere die Kombination von Polymeren mit linearen optischen Eigenschaften und solchen mit nichtlinearen optischen Eigenschaften, ermöglicht werden soll. Außerdem soll das Verfahren weniger aufwendig sein als die Verfahren nach dem Stand der Technik, so daß eine Massenfertigung möglich wird.

Diese Aufgabe wird mit den Verfahren gemäß den Patentansprüche 1 und 3 gelöst. Vorteilhafte Ausgestaltungen sind Gegenstand der Unteransprüche.

Die Erfindung geht von der Erkenntnis aus, daß mittels der Röntgentiefenlithographie nicht nur Wellenleiterstrukturen, sondern auch Mikroküvettenstrukturen herstellbar sind, in die Material mit nicht linearen optischen Eigenschaften eingebracht wird.

Gemäß einer ersten Ausführungsform wird mittels der Röntgentiefenlithographie und der Mikroabformtechnik ein Formeinsatz mit einer Wellenleiterstruktur als Positivform hergestellt. Mittels dieses Formeinsatzes wird die Wellenleiterstruktur in ein Trägermaterial aus Polymeren eingeprägt und anschließend die eingeprägte Wellenleiterstruktur mit optisch linearem Material gefüllt. Als polymeres Trägermaterial wird ein solches gewählt, das einen auf das optisch lineare Material abgestimmten Brechungsindex aufweist, so daß ein planarer Lichtwellenleiter ausgebildet wird. Nach dem Ausfüllen der Wellenleiterstruktur mit optisch linearem Material wird mittels der Röntgentiefenlithographie zumindest im optisch linearen Bereiches mindestens eine Mikroküvettenstruktur hergestellt. Anschließend wird in die Mikroküvettenstruktur optisch nicht lineares Material eingebracht.

Vorzugsweise werden bei der Herstellung der Mikroküvettenstruktur gleichzeitig die an der Mikroküvette anschließenden Wellenleiterenden strukturiert. Insbesondere können durch diese Strukturierung die Endflächen an den Lichtwellenleitern gekrümmt ausgebildet oder mit diffraktiven Strukturen versehen werden, mit denen die Energiestromdichte des Lichtes vergrößert oder verkleinert werden kann.

Gemäß einer weiteren Ausführungsform wird die Mikroküvettenstruktur nicht mittels der Röntgentiefenlithographie hergestellt sondern mittels eines weiteren Formeinsatzes, der ebenfalls mittels der Röntgentiefenlithographie und der Mikroabformtechnik hergestellt worden ist. Mittels dieses Formeinsatzes, der die Mikroküvettenstruktur aufweist, wird diese zumindest in den Bereichen des optisch linearen Bereiches eingeprägt. Nach dem Einprägen wird die Mikroküvettenstruktur mit optisch nicht linearem Material ausgefüllt.

Das nicht lineare optische Material ist vorzugsweise ebenfalls ein Polymeres. Geeignete Materialien sind Polyphenylenvinylen (PPV), Polyhenylacetylen (PPA), Polynaphtylenvinylen (PNV).

Das optisch nicht lineare Material kann ein flüssiges Polymeres sein, das nach dem Einbringen in die Mikroküvettenstruktur im flüssigen Zustand verbleibt.

Durch eine Deckschicht wird das flüssige optisch nicht lineare Material verschlossen. Als Deckschicht eignet sich beispielsweise Glas.

Das optisch nicht lineare Material kann nach dem Einbringen in die Mikroküvettenstruktur mittels einer Niedertemperaturplasmabehandlung oder mittels geeigneter Strahlung verfestigt werden. In diesem Fall kann auf eine Deckschicht verzichtet werden.

Anstatt die Mikroküvettenstruktur mit einem flüssigen Polymeren auszufüllen, kann in die Mikroküvettenstruktur auch ein Festkörper mit nicht linearen Eigenschaften eingesetzt werden. Geeignet hierzu sind Kristalle, beispielsweise aus Bariumtitanat. In diesen Fällen kann der nicht lineare optische Festkörper auch zuerst auf das Substrat aufgebracht werden und die nach dem erfindungsgemäßen Verfahren hergestellte Mikroküvettenstruktur anschließend auf das Substrat aufgesetzt werden, so daß diese den nicht linearen optischen Festkörper umgibt.

Vorzugsweise wird die gesamte Mikrostruktur mit einer Deckschicht versehen, die aus Glas besteht oder als Bestandteil Glas aufweist. Sowohl das Substrat als auch die Deckschicht oder Deckplatte besitzen vorzugsweise einen kleineren Brechnungsindex als das nicht lineare optische Material bzw. das die Mikroküvettenstruktur bildende Material.

Um ggf. die optischen Eigenschaften über ein elektrisches Feld beeinflussen zu können, werden im Bereich des nicht linearen optischen Materials Elektroden eingebracht. Dies kann dadurch geschehen, daß nach dem Ausbilden der Mikroküvettenstruktur im Bereich des nicht linearen optischen Materials eine Metallschicht für die erste Elektrode und nach dem Einbringen des nicht linearen optischen Materials eine zweite Metallschicht für die zweite Elektrode aufgebracht wird. Eine andere Möglichkeit besteht darin, die Deckschicht vor dem Aufbringen mit einer entsprechenden metallischen Beschichtung zu versehen. Besteht das nicht lineare optische Material aus einem Festkörper, so kann dieser vor dem Einbringen in die Mikroküvettenstruktur mit den entsprechenden elektrisch leitenden Beschichtungen versehen werden.

Da durch den Einsatz der Röngentiefenlithographie der Ausgestaltung der Wellenleiterstrukturen und der Mikroküvettenstrukturen keine Grenzen gesetzt sind, können die unterschiedlichsten Mikrobauelemente, wie Koppler, Gatter oder Schalter hergestellt werden. Darüber hinaus können unterschiedliche Polymermaterialien miteinander kombiniert werden, wodurch aufgrund der besseren optischen Eigenschaften dieser Materialien hinsichtlich ihrer Leistung verbesserte aktive optische Mikrobauelemente hergestellt werden können. Die Fertigungszeiten für die Mikrobauelemente sind kürzer als bei den Verfahren nach dem Stand der Technik, was insbesondere darauf zurückzuführen ist, daß die Formeinsätze zum Einprägen der Strukturen mehrfach verwendet werden können, ohne daß Qualitätseinbußen beim fertigen Mikrobauelement feststellbar sind.

Beispielhafte Ausgestaltungen der Erfindung werden nachfolgend anhand der Zeichnungen näher erläutert, die die Herstellung eines Mikroschalters veranschaulichen.

Es zeigen:
- Figur 1: die perspektivische Darstellung eines Mikrobauelementes in Form eines Schalters,
- Figur 2: einen Schnitt längs der Linie II-II des in Figur 1 gezeigten Schalters und
- Figur 3a -i: die Herstellungsschritte gemäß einer Ausführungsform des Verfahrens bezogen auf einen Schnitt längs der Linie III-III des in Figur 1 gezeigten Schalters.

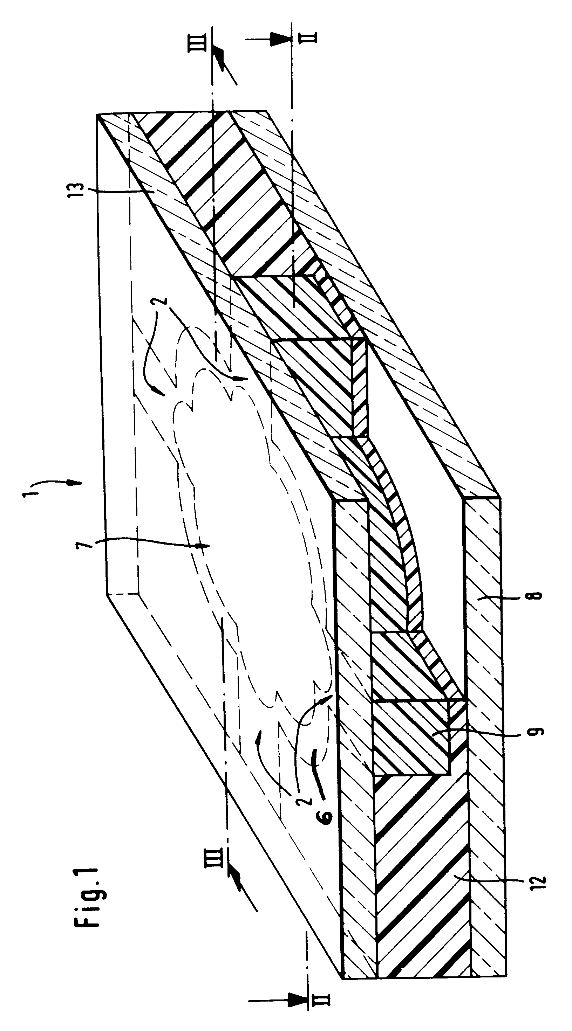

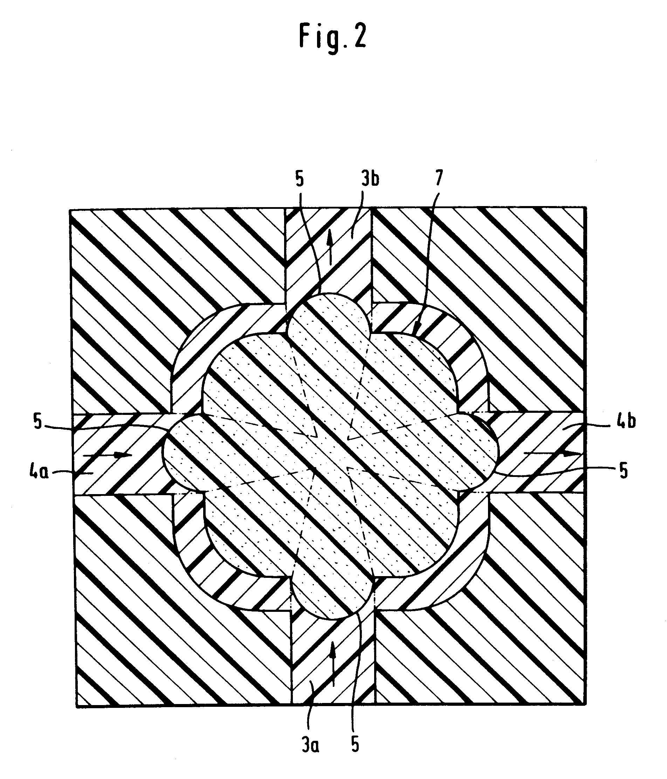

In der Figur 1 ist ein integriertoptischer Mikroschalter 1 perspektivisch dargestellt, wobei im Bereich der vorderen rechten Ecke der mittlere Bereich des Mikrobauelementes 1 zur Verdeutlichung der Mikrostruktur weggelassen wurde. Wie insbesondere auch aus Figur 2 zu entnehmen ist, besitzt der Mikroschalter 1 eine Wellenleiterstruktur 2 in Form von zwei sich kreuzenden Wellenleitern 3a, b, 4a, b. Im Kreuzungsbereich der Wellenleiter 3, 4 befindet sich ein aus dem gleichen Material wie die Wellenleiter 3, 4 gebildeter Zentralbereich 6, in dem eine Mikroküvettenstruktur 7 ausgebildet ist, die mit optisch nicht linearem Material ausgefüllt ist. Die Lichtwellenleiterenden 5, die an die Mikroküvettenstruktur angrenzen, sind gekrümmt ausgeführt, um das Licht - wie in Figur 2 zu sehen ist - zu fokussieren. Über die beispielsweise in den Lichtwellenleiter 4a eingespeiste Lichtintensität kann die Durchlässigkeit des optisch nicht linearen Materials innerhalb der Mikroküvettenstruktur 7 gesteuert werden, so daß das vom Lichtwellenleiter 3a,b geführte Licht geschaltet werden kann.

Wie in Figur 1 zu sehen ist, befindet sich auf einem Substrat 8 ein die Wellenleiterstruktur 2 und den Zentralbereich 6 bildendes optisch lineares Material, wie z.B. PMMA. Das die Wellenleiter 3, 4 umgebende Füllmaterial 12 besteht aus fluoriertem PMMA.

Die gesamte Wellenleiterstruktur 2 sowie die Mikroküvettenstruktur 7 sind mittels einer Deckschicht 13 abgedeckt, die ebenso wie das Substrat 8 aus Glas bestehen kann.

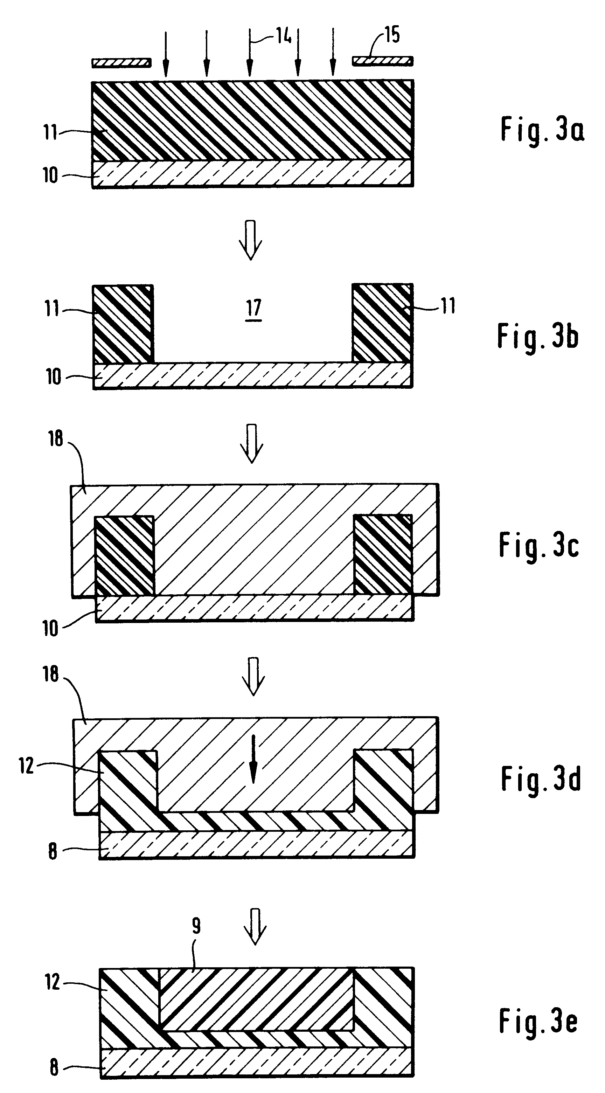

Die Herstellung eines derartigen optischen Mikrobauelementes 1 wird nachfolgend im einzelnen beschrieben, wobei die Figuren 3a bis 3i die Herstellungsschritte bezogen auf einen Schnitt längs der Linie III-III in Figur 1 verdeutlichen.

In der Figur 3a ist der erste Verfahrensschritt dargestellt. Das auf einem Substrat 10 befindliche Resistmaterial 11 wird mittels Röntgenstrahlung 14, das durch eine Maske 15 hindurchtritt, bestrahlt. Die Maske 15 weist die Wellenleiterstruktur 2 und die Mikroküvettenstruktur 7 auf. Nach der Bestrahlung werden - wie in Figur 3b gezeigt - die bestrahlten Bereiche freigelegt, so daß ein Freiraum 17 entsteht. Die verbleibenden Bestandteile des Resistmaterials 11 werden mittels Galvanoformung zur Bildung eines Formeinsatzes 18 abgeformt (s. Figur 3c). Der Formeinsatz 18 besitzt somit die Wellenleiterstruktur und die Mikroküvettenstruktur als Positivform.

In einem weiteren Verfahrensschritt wird mittels des Formeinsatzes 18 die Mikrostruktur in ein auf ein Substrat 8 befindliches Polymermaterial 12 eingeprägt. Der hierbei entstehende Freiraum nach Entfernen des Formeinsatzes 18 wird mit optisch linearem Material 9 gefüllt.

Für die Ausbildung der Mikroküvettenstruktur gibt es zwei Alternativverfahrensschritte.

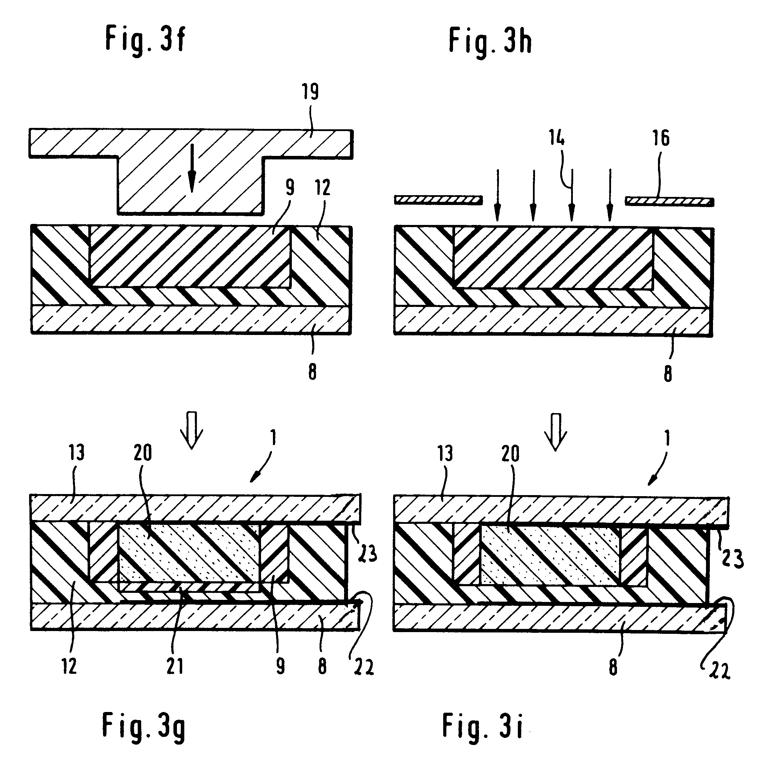

In der Figur 3f wird die Mikroküvettenstruktur 7 mittels eines weiteren Formeinsatzes 19 in das optisch lineare Material 9 eingeprägt. Der Formeinsatz 19 wird vorzugsweise auf die gleiche Weise hergestellt wie der Formeinsatz 18. Der hierbei entstehende Freiraum wird anschließend mit optisch nicht linearem Material 20 ausgefüllt. Zum Schluß wird dann noch eine Deckschicht 13 aufgebracht.

Wie in der Figur 3g zu sehen ist, befindet sich unter dem nicht linearen Material 20 eine dünne Schicht 21 aus optisch linearem Material, das beim Einprägen verdrängt worden ist.

Die andere Variante der Herstellung der Mikroküvettenstruktur ist in der Figur 3h dargestellt. Mittels einer weiteren Maske 16, die die Struktur der Mikroküvettenstruktur aufweist, wird wiederum eine Bestrahlung mittels Röntgenstrahlen 14 vorgenommen. Die bestrahlten Bereiche werden anschließend freigelegt und mit optisch nicht linearem Material 20 aufgefüllt, wie in Figur 3i dargestellt ist. Das Bauteil 1 gemäß Figur 3i unterscheidet sich von dem gemäß Figur 3g hergestellten Bauteil durch die nicht vorhandene dünne Schicht 21 aus optisch linearem Material unter dem nicht linearen Material 20.

Um auch hier die Mikrostruktur zu einem Lichtwellenleiter zu machen, besitzt die Deckplatte 13 einen kleineren Brechungsindex als das Füllmaterial 12. Wenn sich zwischen dem Substrat 8 und dem nichtlinearen optischen Material kein Füllmaterial 12 befindet, muß auch das Substrat 8 einen kleineren Brechnungsindex aufweisen als das Füllmaterial. Dies kann z.B. dadurch erreicht werden, daß das Substrat 8 und die Deckplatte 13 jeweils aus zwei Schichten bestehen, wobei z.B. die innere, dem Mikrobauelement zugewandte Schicht aus vorvernetztem fluoriertem PMMA und die äußere Schicht aus Glas oder Phenolharz bestehen kann.

In den Figuren 3g und 3i sind die beiden Elektroden 22 und 23 eingezeichnet. Die untere Elektrode 22 ist direkt auf die Oberseite des Substrates 8 als dünne Metallschicht aufgedampft oder aufgesputtert. Falls erforderlich, kann sie durch photolithographische Verfahren strukturiert sein. Die obere Elektrode 28 ist in gleicher Weise auf die Unterseite der Deckschicht oder Deckplatte 13 aufgebracht. Beide Elektroden 22, 23 sind mit Anschlüssen versehen.

### Bezugszeichenliste:

- 1: Mikrobauelement
- 2: Wellenleiterstruktur
- 3a,b: Wellenleiter
- 4a,b: Wellenleiter
- 5: Wellenleiterenden
- 6: Zentralbereich
- 7: Mikroküvettenstruktur
- 8: Substrat
- 9: wellenleitende Schicht
- 10: erstes Substrat
- 11: Resistmaterial
- 12: Füllmaterial
- 13: Deckschicht
- 14: Röntgenstrahlung
- 15: erste Maske
- 16: zweite Maske
- 17: Freiraum
- 18: Formeinsatz
- 19: Formeinsatz
- 20: optisch nichtlineares Material
- 21: Schicht aus optisch linearem Material
- 22: untere Elektrode
- 23: obere Elektrode

## Patentansprüche

1. Verfahren zur Herstellung von nicht linearen optischen Mikrobauelementen, bei dem mittels Röntgentiefenlithographie und Mikroabformtechnik ein Formeinsatz mit einer Wellenleiterstruktur als Positivform hergestellt wird, die Wellenleiterstruktur mittels des Formeinsatzes in ein Trägermaterial aus Polymeren eingeprägt wird und anschließend die eingeprägte Wellenleiterstruktur mit optisch linearem Material gefüllt wird, dadurch gekennzeichnet,
daß nach dem Ausfüllen der Wellenleiterstruktur mittels der Röntgentiefenlithographie zumindest in den Bereichen des optisch linearen Materials mindestens eine Mikroküvettenstruktur hergestellt wird und
daß in die Mikroküvettenstruktur optisch nicht lineares Material eingebracht wird.

2. Verfahren nach Anspruch 1, dadurch gekennzeichnet, daß bei der Herstellung der Mikroküvettenstruktur gleichzeitig die an der Mikroküvette anschließenden Wellenleiterenden strukturiert werden.

3. Verfahren zur Herstellung von nicht linearen optischen Mikrobauelementen, bei dem mittels Röntgentiefenlithographie und Mikroabformtechnik ein Formeinsatz mit einer Wellenleiterstruktur als Positivform hergestellt wird, die Wellenleiterstruktur mittels des Formeinsatzes in ein Trägermaterial aus Polymeren eingeprägt wird und anschließend die eingeprägte Wellenleiterstruktur mit optisch linearem Material gefüllt wird, dadurch gekennzeichnet,
daß zumindest in den Bereichen des optisch linearen Materials mindestens eine Mikroküvettenstruktur mittels eines weiteren mittels Röntgentiefenlithographie und Mikroabformtechnik hergestellten Formeinsatzes eingeprägt wird, und daß in die Mikroküvettenstruktur optisch nichtlineares Material eingebracht wird.

4. Verfahren nach Anspruch 3, dadurch gekennzeichnet, daß beim Einprägen der Mikroküvettenstruktur gleichzeitig die an der Mikroküvette anschließenden Wellenleiterenden strukturiert werden.

5. Verfahren nach einem der Ansprüche 1 bis 4, dadurch gekennzeichnet, daß als nicht lineares optisches Material Polymere verwendet werden.

6. Verfahren nach einem der Ansprüche 1 bis 5, dadurch gekennzeichnet, daß zumindest im Bereich des nicht linearen optischen Materials eine Deckschicht aufgebracht wird.

7. Verfahren nach einem der Ansprüche 1 bis 6, dadurch gekennzeichnet, daß das nicht lineare optische Material nach dem Einbringen in die Mikroküvetten-Struktur flüssig bleibt und durch eine Deckschicht verschlossen wird.

8. Verfahren nach Anspruch 7, dadurch gekennzeichnet, daß eine Deckschicht aus Glas verwendet wird.

9. Verfahren nach einem der Ansprüche 1 bis 8, dadurch gekennzeichnet, daß das nicht lineare Material nach Einbringen in die Mikroküvettenstruktur mittels einer Niedertemperaturplasmabehandlung oder mittels geeigneter Strahlung verfestigt wird.

10. Verfahren nach einem der Ansprüche 1 bis 9, dadurch gekennzeichnet, daß das nicht lineare optische Material mit Elektroden versehen wird.
